# EUROPEAN PATENT APPLICATION

(11) **EP 4 167 029 A1**
(43) Date of publication of application: **19.04.2023**
(21) Application number: 21202729.6
(22) Date of filing: 14.10.2021
(51) Int. Cl.: G03F 7/20

(54) **A FLUID EXTRACTION SYSTEM, METHOD AND LITHOGRAPHIC APPARATUS**

(71) Applicant: ASML Netherlands B.V., 5500 AH Veldhoven (NL)
(72) Inventor: SMEETS, Benjamin, Cunnegonda, Henricus, 5500 AH Veldhoven (NL); LINSSEN, Bram, Peter, Johan, 5500 AH Veldhoven (NL); ROOS, Willem, Arie, 5500 AH Veldhoven (NL); FRENCKEN, Mark, Johannes, Hermanus, 5500 AH Veldhoven (NL)
(74) Representative: ASML Netherlands B.V.

(57) **Abstract**

Disclosed herein is a fluid extraction system for a lithographic apparatus, the fluid extraction system configured to extract fluid, that a fluid handling system, comprising a fluid handling structure, is arranged to supply, along a flow path that comprises a gap between an edge of a substrate and an edge of a surrounding structure of the substrate; and a controller arranged to control the flow rate of the fluid in the flow path in dependence on one or more of a property of the substrate, a property of the fluid handling system, a property of the fluid handling structure, a property of the fluid extraction system, and the separation between the fluid handling structure and the fluid extraction system.

## Description

### FIELD

The present invention relates to a fluid handling system and a device manufacturing method. The present invention also relates to the lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

Further improvements in the resolution of smaller features may be achieved by providing an immersion fluid having a relatively high refractive index, such as water, on the substrate during exposure. The effect of the immersion fluid is to enable imaging of smaller features since the exposure radiation will have a shorter wavelength in the fluid than in gas. The effect of the immersion fluid may also be regarded as increasing the effective numerical aperture (NA) of the system and also increasing the depth of focus. The immersion fluid may be confined to a localized area between the projection system of the lithographic apparatus and the substrate by a fluid handling structure.

### SUMMARY

It is an object of the present invention to provide a fluid handling system and method with improved performance over known techniques.

According to a first aspect of the present invention, there is provided a fluid extraction system for a lithographic apparatus, the fluid extraction system configured to extract fluid, that a fluid handling system, comprising a fluid handling structure, is arranged to supply, along a flow path that comprises a gap between an edge of a substrate and an edge of a surrounding structure of the substrate; and a controller arranged to control the flow rate of the fluid in the flow path in dependence on one or more of a property of the substrate, a property of the fluid handling system, a property of the fluid handling structure, a property of the fluid extraction system, and the separation between the fluid handling structure and the fluid extraction system.

According to a second aspect of the present invention, there is provided a fluid extraction system for a lithographic apparatus, the fluid extraction system configured to extract fluid, that a fluid handling system, comprising a fluid handling structure, is arranged to supply, along a flow path that comprises a gap between an edge of a substrate and an edge of a surrounding structure of the substrate; and a controller arranged to control the flow rate of the fluid along the flow path in dependence on the scanning pattern of the substrate, a property of the substrate, a property of the fluid handling system, a property of the fluid handling structure, a property of the fluid extraction system, and the separation between the fluid handling structure and the fluid extraction system; wherein the controller is arranged to control the flow rate of the fluid in the flow path such that the flow rate is changeable between any one of plurality of different flow rates between a maximum flow rate and there being no fluid flow.

According to a third aspect of the present invention, there is provided a lithographic apparatus comprising: a fluid handling system comprising a fluid handling structure; and the fluid extraction system of any preceding aspect; wherein the fluid handling structure is configured to confine immersion liquid to a space between a part of a projection system and a surface of a substrate in the lithographic apparatus whereby a radiation beam projected from the projection system can irradiate the surface of the substrate by passing through the immersion liquid.

According to a fourth aspect of the present invention, there is provided a device manufacturing method in a lithographic apparatus having a projection system configured to project a radiation beam onto a substrate, and a fluid handling system comprising a fluid handling structure configured to confine immersion liquid to a liquid confinement space between a part of a projection system and a surface of a substrate in the lithographic apparatus whereby a radiation beam projected from the projection system can irradiate the surface of the substrate by passing through the immersion liquid, the method comprising: using the fluid handling structure to confine the immersion liquid to the space between at least a part of the fluid handling structure and the surface of the substrate; projecting a patterned beam of radiation onto the substrate through the immersion liquid in the space; extracting a fluid along a fluid flow path that comprises a gap between an edge of the substrate and an edge of a surrounding structure of the substrate; and controlling the flow rate of the fluid along the fluid flow path in dependence on one or more of a property of the substrate, a property of the fluid handling system, a property of the fluid handling structure, a property of the fluid extraction system, and the separation between the fluid handling system and the fluid extraction system.

Further embodiments, features and advantages of the present invention, as well as the structure and operation of the various embodiments, features and advantages of the present invention, are described in detail below with reference to the accompanying drawings.

### DESCRIPTION OF THE DRAWINGS

Embodiments of the invention will now be described, by way of example only, with reference to the accompanying schematic drawings, in which corresponding reference symbols indicate corresponding parts, and in which:
Figure 1 depicts the schematic overview of the lithographic apparatus;
Figure 2A shows part of a fluid handling system according to an embodiment; and
Figures 2B shows part of a fluid handling system according to an embodiment.

The features shown in the figures are not necessarily to scale, and the size and/or arrangement depicted is not limiting. It will be understood that the figures include optional features which may not be essential to the invention. Furthermore, not all of the features of the apparatus are depicted in each of the figures, and the figures may only show some of the components relevant for describing a particular feature.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

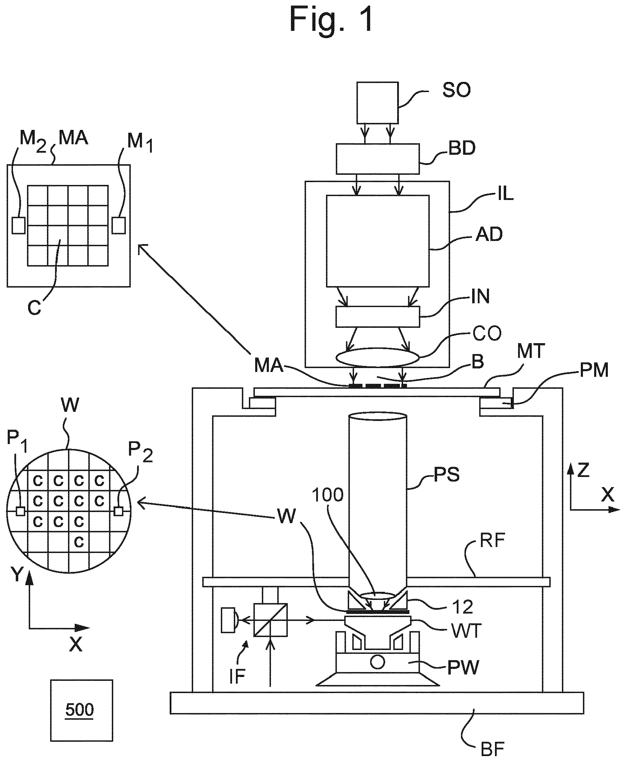

Figure 1 schematically depicts a lithographic apparatus. The lithographic apparatus includes an illumination system (also referred to as illuminator) IL configured to condition a radiation beam B (e.g., UV radiation or DUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a substrate table) WT constructed to hold a substrate (e.g., a resist coated wafer) W and connected to a second positioner PW configured to accurately position the substrate support WT in accordance with certain parameters, and a projection system (e.g., a refractive projection lens system) PS configured to project a pattern imparted to the radiation beam B by patterning device MA onto a target portion C (e.g., comprising one or more dies) of the substrate W. A controller 500 controls the overall operation of the apparatus. Controller 500 may be a centralised control system or a system of multiple separate sub-controllers within various sub-systems of the lithographic apparatus.

In operation, the illumination system IL receives the radiation beam B from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus is of a type wherein at least a portion of the substrate W may be covered by an immersion liquid having a relatively high refractive index, e.g., water, so as to fill an immersion space 11 between the projection system PS and the substrate W - which is also referred to as immersion lithography. More information on immersion techniques is given in US 6,952,253, which is incorporated herein by reference.

The lithographic apparatus may be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus may comprise a measurement stage (not depicted in figures). The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

Immersion techniques have been introduced into lithographic systems to enable improved resolution of smaller features. In an immersion lithographic apparatus, a liquid layer of immersion liquid having a relatively high refractive index is interposed in the immersion space between a projection system PS of the apparatus (through which the patterned beam is projected towards the substrate W) and the substrate W. The immersion liquid covers at least the part of the substrate W under a final element of the projection system PS. Thus, at least the portion of the substrate W undergoing exposure is immersed in the immersion liquid.

In commercial immersion lithography, the immersion liquid is water. Typically the water is distilled water of high purity, such as Ultra-Pure Water (UPW) which is commonly used in semiconductor fabrication plants. In an immersion system, the UPW is often purified and it may undergo additional treatment steps before supply to the immersion space as immersion liquid. Other liquids with a high refractive index can be used besides water as the immersion liquid, for example: a hydrocarbon, such as a fluorohydrocarbon; and/or an aqueous solution. Further, other fluids besides liquid have been envisaged for use in immersion lithography.

In this specification, reference will be made in the description to localized immersion in which the immersion liquid is confined, in use, to the immersion space between the final element and a surface facing the final element. The facing surface is a surface of substrate W or a surface of the supporting stage (or substrate support WT) that is co-planar with the surface of the substrate W. (Please note that reference in the following text to surface of the substrate W also refers in addition or in the alternative to the surface of the substrate support WT, unless expressly stated otherwise; and vice versa). A fluid handling structure present between the projection system PS and the substrate support WT is used to confine the immersion liquid to the immersion space. The immersion space filled by the immersion liquid is smaller in plan than the top surface of the substrate W and the immersion space remains substantially stationary relative to the projection system PS while the substrate W and substrate support WT move underneath.

Other immersion systems have been envisaged such as an unconfined immersion system (a so-called 'All Wet' immersion system) and a bath immersion system. In an unconfined immersion system, the immersion liquid covers more than the surface under the final element. The liquid outside the immersion space is present as a thin liquid film. The liquid may cover the whole surface of the substrate W or even the substrate W and the substrate support WT co-planar with the substrate W. In a bath type system, the substrate W is fully immersed in a bath of immersion liquid.

The fluid handling structure is a structure which supplies the immersion liquid to the immersion space, removes the immersion liquid from the immersion space and thereby confines the immersion liquid to the immersion space. It includes features which are a part of a fluid supply system. The arrangement disclosed in PCT patent application publication no. WO 99/49504 is an early fluid handling structure comprising pipes which either supply or recover the immersion liquid from the immersion space and which operate depending on the relative motion of the stage beneath the projection system PS. In more recent designs, the fluid handling structure extends along at least a part of a boundary of the immersion space between the final element 100 of the projection system PS and the substrate support WT or substrate W, so as to in part define the immersion space.

The fluid handing structure may have a selection of different functions. Each function may be derived from a corresponding feature that enables the fluid handling structure to achieve that function. The fluid handling structure may be referred to by a number of different terms, each referring to a function, such as barrier member, seal member, fluid supply system, fluid removal system, liquid confinement structure, etc..

As a barrier member, the fluid handling structure is a barrier to the flow of the immersion liquid from the immersion space. As a liquid confinement structure, the structure confines the immersion liquid to the immersion space. As a seal member, sealing features of the fluid handling structure form a seal to confine the immersion liquid to the immersion space. The sealing features may include an additional gas flow from an opening in the surface of the seal member, such as a gas knife.

In an embodiment the fluid handling structure may supply immersion fluid and therefore be a fluid supply system.

In an embodiment the fluid handling structure may at least partly confine immersion fluid and thereby be a fluid confinement system.

In an embodiment the fluid handling structure may provide a barrier to immersion fluid and thereby be a barrier member, such as a fluid confinement structure.

In an embodiment the fluid handling structure may create or use a flow of gas, for example to help in controlling the flow and/or the position of the immersion fluid.

The flow of gas may form a seal to confine the immersion fluid so the fluid handling structure may be referred to as a seal member; such a seal member may be a fluid confinement structure.

In an embodiment, immersion liquid is used as the immersion fluid. In that case the fluid handling structure may be a liquid handling system. In reference to the aforementioned description, reference in this paragraph to a feature defined with respect to fluid may be understood to include a feature defined with respect to liquid.

A lithographic apparatus has a projection system PS. During exposure of a substrate W, the projection system PS projects a beam of patterned radiation onto the substrate W. To reach the substrate W, the path of the radiation beam B passes from the projection system PS through the immersion liquid confined by the fluid handling structure 12 between the projection system PS and the substrate W. The projection system PS has a lens element, the last in the path of the beam, which is in contact with the immersion liquid. This lens element which is in contact with the immersion liquid may be referred to as 'the last lens element' or "the final element". The final element 100 is at least partly surrounded by the fluid handling structure 12. The fluid handling structure 12 may confine the immersion liquid under the final element 100 and above the facing surface.

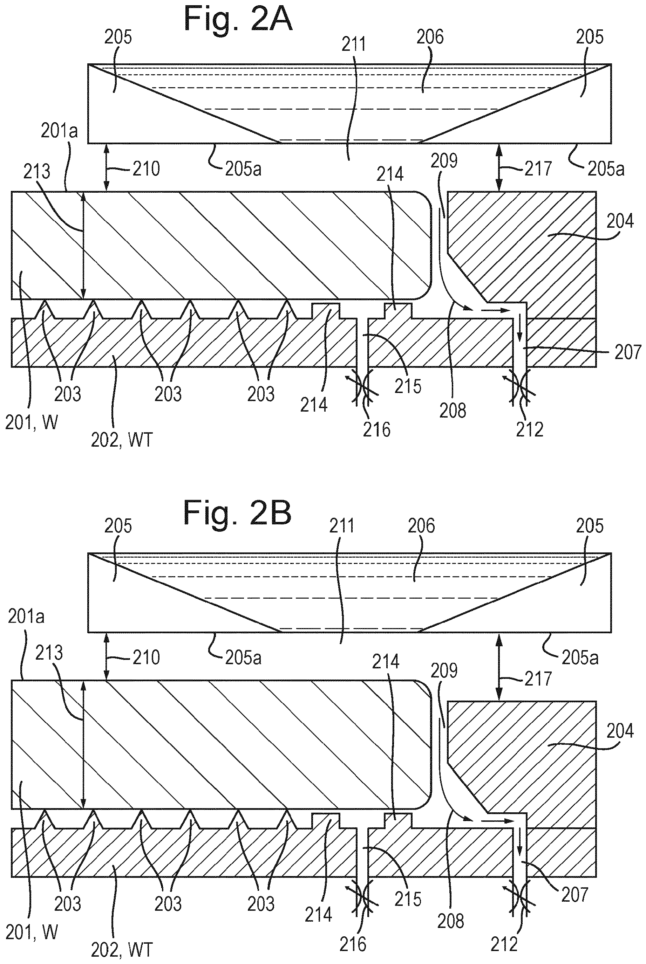

Figure 2A illustrates part of a lithographic apparatus according to an embodiment. The arrangement illustrated in Figure 2A, and described below, may be applied to the lithographic apparatus described above and illustrated in Figure 1.

Figure 2A is a cross-section through a substrate table 202, a substrate 201, a surrounding structure 204 of the substrate 201, and part of a fluid handling system. The substrate 201 may be the substrate W as shown in Figure 1. The substrate table 201 may be the substrate table WT as shown in Figure 1. The fluid handling system comprises a liquid bath 206 and a fluid handling structure 205. The fluid handling structure 205 supplies the immersion liquid to the immersion space 211, removes the immersion liquid from the immersion space 211 and thereby confines the immersion liquid to the immersion space 211. The fluid handling structure 205 has a lower surface 205a. The fluid handling structure 205 may be the fluid handling structure 12 as shown in Figure 1.

The substrate 201 is held by the substrate table 202. The substrate 201 may be supported on one or more projections 203, i.e., burls 203, of the substrate table 202. An under-pressure, and/or clamping force, may be applied between the substrate 201 and the substrate table 202 to hold the substrate 201 in place. The substrate table 202 may also comprise two concentric rings 214 that are not intended to support the substrate 201.

The surrounding structure 204 of the substrate 201 may extend circumferentially around the substrate 201. The surrounding structure 204 may be a separate structure from the substrate table 202. Alternatively, the surrounding structure 204 may be part of the substrate table 202. The surrounding structure 204 may be shaped, in plan, as a ring and surround the outer edge of the substrate 201. The surrounding structure 204 of the substrate 201 may alternatively be referred to as a cover ring 204.

The lower surface 205a of the fluid handling structure 205 is separated from an upper surface 201a of the substrate 201 by a first separation distance 210. The first separation distance 210 may be referred to as the fly height of the fluid handling structure 205 above the substrate 201. A second separation distance 217 may defined as the separation of the lower surface 205a of the fluid handling structure 205 and the upper surface of the surrounding structure 204. The second separation distance 217 may be referred to as the fly height of the fluid handling structure 205 above the surrounding structure 204. When the upper surface 201a of the substrate 201 is in the same plane as the upper surface of the surrounding structure 204, as shown in Figure 2A, the fly height above the substrate 201 is the same as the fly height above the surrounding structure 204.

The liquid bath 206 is arranged so that the liquid in it may flow into an immersion space 211. The immersion space 211 is partially bounded by the lower surface 205a of the fluid handling structure 205 and the upper surface 201a of the substrate 201 and/or the upper surface of the substrate table 202, e.g., the upper surface of the surrounding structure 204.

There is a gap 209 between an edge of the substrate 201 and an edge of the surrounding structure 204. There is also a fluid channel 207 through the substrate table 202 and/or the surrounding structure 204. There is a fluid flow path 208 arranged so that fluid in the immersion space 211 may flow through the gap 209 and then flow through the fluid channel 207. The fluid channel 207 may be located radially outwards from the edge of the substrate 201. There may be a variable valve 212 in the fluid channel 207. The variable valve 212 may also be referred to as a proportional valve. The variable valve 212 is arranged to control the flow of fluid through the fluid channel 207. The fluid channel 207 and variable valve 212 are part of a fluid extraction system according to an embodiment.

In use of the lithographic apparatus, the fluid handling structure 205 may move relative to the substrate 201 and substrate table 202. During this relative movement, the fluid handling structure 205 may move across the gap 209. In particular, when the edge of the substrate 201 is being imaged, or at other times such as when the substrate 201 first moves under the projection system PS, the immersion liquid in the immersion space 211 may flow into the gap 209.

The fluid extraction system may extract, along the fluid channel 207, any immersion liquid that flows in the gap 209. Another function of the fluid extraction system is to prevent gas in the gap 209 escaping into the immersion space 211. If gas does escape into the immersion space 211, this can lead to a bubble which floats within the immersion space 211. Such a bubble, if in the path of the radiation beam B, may lead to an imaging error. The fluid extraction system is also configured to remove gas from the gap 209. The fluid channel 207 may therefore be arranged to extract both gas and immersion liquid. The fluid flow through the fluid channel 207 may therefore be a two phase flow.

There is a general desire for the number of stacked layers on a substrate 201 to be increased, as is required for the manufacture of more advanced 3D structures. There is a related desire for the ability to operate a lithographic apparatus with substrates that have different heights.

Figures 2A and 2B show the relative arrangements of a fluid handling system and fluid extraction system when substrates 201 with two different substrate heights 213 are used. The substrate 201 shown in Figure 2B has a larger substrate height 213 than the substrate 201 shown in Figure 2A. There is a minimum first separation distance 210 of the fluid handling structure 205 above the upper surface 201a of the substrate 201 that needs to be maintained. If the minimum first separation distance 210 is not maintained, then there may be a collision between the fluid handling structure 205 and the substrate 201. It may therefore be necessary to increase the second separation distance 217, between the liquid confinement structure 205 and fluid extraction system, when there is an increase in the substrate height 213. Accordingly, in Figure 2B, the second separation distance 217 is larger than in Figure 2A. For example, the lithographic apparatus may be required to operate with substrate heights 213 in the range of about 770µm to about 850µm. The minimum separation distance 210 that needs to be maintained may be about 135µm. A fluid handling structure 205 and fluid extraction system that are configured to operate with a substrate height 213 of about 770µm may be unable to operate with a substrate height 213 of about 850µm without the separation between the fluid handling structure 205 and fluid extraction system being increased.

Any changes to the separation between the liquid confinement structure 205 and fluid extraction system, and/or change of the substrate height 213, will change the fluid flow conditions in the immersion space 211. The fluid flow rate through the fluid channel 207 of the fluid extraction system should be appropriate given the fluid flow conditions in the immersion space 211. The fluid flow rate through the fluid channel 207 needs to be large enough to appropriately extract gas and immersion liquid. However, if the fluid flow rate through the fluid channel 207 is too large, there will be an over extraction of the immersion liquid and this may cause problems such as increasing the occurrence of evaporate cold spots on the substrate 201 and/or an increase of gas in the immersion space 211.

In known fluid extraction systems, the valve in the fluid channel 207 is not a variable valve. The valve is therefore either fully open or fully closed. When the valve is open, gas and/or immersion liquid are extracted along the fluid channel 207. When the valve is closed, there is no flow of gas and/or immersion liquid along the fluid channel 207. It is the initial configuration of the fluid extraction system that determines the fluid flow rate through the fluid channel 207 when the valve is open. The fluid flow rate through the fluid channel 207 can be stopped by closing the valve. However, the fluid flow rate through the fluid channel 207 cannot be otherwise controlled to be a different flow rate to that determined by the initial configuration of the fluid extraction system.

A problem with known fluid extraction systems is that, when the valve is open, the fluid flow rate through the fluid channel 207 may not be appropriate for the fluid flow conditions in the immersion space 211. In particular, known fluid extraction systems are unable to adapt their operation as is required to allow changes to the substrate height 213.

Embodiments solve the above problem experienced by known systems. In embodiments, the fluid extraction system comprises a variable valve 212. The variable valve 212 allows the fluid flow rate through the fluid channel 207 to be controlled. The fluid flow rate through the fluid channel 207 may therefore be changed to be an appropriate flow rate given any changes to the fluid flow conditions in the immersion space 211. This ensures that the fluid flow rate through the fluid channel 207 is appropriate given any changes to the substrate height 213.

Embodiments include a controller that is arranged to control the operation, i.e. state, of the variable valve 212. The controller may be the controller 500 as shown in Figure 1 or a separate controller. The controller may therefore control the fluid flow rate through the fluid channel 207 by controlling the operation of the variable valve 212. The controller may also be arranged to control the operation of other parts of the lithographic apparatus. For example, the controller may the same controller of fluid flows into, and out of, the fluid handling structure.

The controller may also be able to control the configuration of parts of the lithographic apparatus. In particular, the controller may be able to change the separation between the fluid handling structure 205 and the fluid extraction system, and/or change the fly height of the fluid handling structure 205. For example, the controller may receive data on the substrate height 213 of the substrate 201 that is, or is about to be, mounted onto the substrate table 202 and then automatically change the separation between the fluid handling structure 205 and the fluid extraction system so that a predetermined first separation distance 210, and/or a predetermined second separation distance 217, is provided. The predetermined first separation distance 210 may be constant or dependent on, for example, the substrate height 213 and/or the intended operation of the lithographic apparatus.

The controller is arranged to control the flow rate of the fluid in the flow path 208 so that the flow rate is changeable between any one of plurality of different flow rates between a maximum flow rate and there being no fluid flow. The flow rate of the fluid in the flow path 208 may therefore be automatically controlled as appropriate for the fluid flow conditions in the immersion space 211.

The controller may be arranged to control the operation of the variable valve 212, and thereby the flow rate of the fluid in the flow path 208, in dependence on received data by the controller. Embodiments include the controller being arranged to control the operation of the variable valve 212, and thereby the flow rate of the fluid in the flow path 208, in dependence on received data substantially in real-time. The controller may control the valve 212 using an open loop that set, or tracks, the valve position. The controller may use a control loop so that the pressure in the fluid channel 207 follow a desired set point.

The received data may include, for example, data on a property of the substrate 201, a property of the fluid handling structure 205 and/or a property of the fluid extraction system. The received data may include any data that may affect the optimal fluid extraction flow rate along the flow path 208. In particular, the received data may include data on one or more of the substrate height 213, the substrate shape, the substrate warpage and the contact angle of the substrate 201, the fluid supply and/or extraction flows within the fluid handling system, the pressure within the fluid flow path 208, the operation of the lithographic apparatus, the fly height 210, and the separation between the fluid handling structure 205 and fluid extraction system.

For example, the received data may include data on the substrate height 213 of the current substrate 201. The controller may then operate the variable valve 212 to change the flow rate of the fluid in the flow path 208 in dependence on the received data on the substrate height 213 of the current substrate. The received data may additionally, or alternatively, include data on the separation between the fluid handling structure 205 and fluid extraction system. The controller may then operate the variable valve 212 to change the flow rate of the fluid in the flow path 208 in dependence on the received data on the separation between the fluid handling structure 205 and fluid extraction system. The received data may additionally, or alternatively, include data on the fluid supply and/or extraction flows of the fluid handling system. The controller may then operate the variable valve 212 to change the flow rate of the fluid in the flow path 208 in dependence on the received data on the fluid supply and/or extraction flows of the fluid handling system.

The received data may additionally, or alternatively, include data on the operation of the lithographic apparatus, such as the scanning pattern of the substrate 201. In particular, certain substrate moves in the scanning pattern of the substrate may increase the presence of gas in the immersion space 211. The increased amount of gas may result in a sudden pressure increase of the fluid in the flow path 208. The controller may operate the variable valve 212 to change the flow rate of the fluid in the flow path 208 in dependence on the scanning pattern of the substrate 201 so as to reduce the magnitude of the pressure variations in the flow path 208.

Embodiments include a device manufacturing method in the lithographic apparatus. The method comprises the steps of: 1) using the fluid handling system comprising a fluid handing structure 205 to confine immersion liquid to the immersion space 211; 2) projecting a patterned beam of radiation onto the substrate 201 through immersion liquid in the immersion space 211; 3) extracting fluid along the fluid flow path 208 that comprises a gap 209 between an edge of the substrate 201 and an edge of the surrounding structure 204 of the substrate 201; and 4) controlling the flow rate of the fluid along the fluid flow path 208 in dependence on a property of the substrate 201, a property of the fluid handling structure 205, and/or a property of the fluid extraction system. The method may further comprise: measuring the substrate height 213; adjusting the separation between the fluid handling structure 205 and the fluid extraction system in dependence on the substrate height 213; and controlling the flow rate of the fluid along the fluid flow path 208 in dependence on the substrate height 213 and/or the separation between the fluid handling structure 205 and the fluid extraction system.

Embodiments also include a number of modifications and variations to the above described techniques.

As shown in Figures 2A and 2B, the fluid extraction system may also comprise a further fluid channel 215 between the concentric rings 214 and a variable valve 216 in the further fluid channel 215. The variable valve 216 may be arranged to control the flow of fluid through the further fluid channel 215. The fluid that flows through the gap 209, or along any other flow path from the immersion space 211, may also be extracted along the further fluid channel 215. In all of the description of embodiments, the variable valve 216 in the further fluid channel 215 may be operated in the same way, or a similar way, to variable valve 212.

For example, in embodiments include a controller that is arranged to change the separation between the fluid handling structure 205 and the fluid extraction system in dependence on the substrate height 213 of the substrate 201 that is, or is about to be, mounted onto the substrate table 202. This may be a separate controller from the controller of the operation of the variable valve 212.

Embodiments also include controlling the fluid supply and/or extraction fluid flows of the fluid handling system in dependence on the received data by the controller. This may be performed in addition to, or as an alternative to, the control of the variable valve 212.

The valve 212 does not need to be located in the fluid channel 207 and may alternatively be located in any location that allows control of the fluid flow along the flow path 208.

The present invention may provide a lithographic apparatus. The lithographic apparatus may have any/all of the other features or components of the lithographic apparatus as described above. For example, the lithographic apparatus may optionally comprise at least one or more of a source SO, an illumination system IL, a projection system PS, a substrate support WT, etc..

Specifically, the lithographic apparatus may comprise the projection system PS configured to project the radiation beam B towards the region of the surface of a substrate W. The lithographic apparatus may further comprise the fluid handling system and/or fluid extraction system as described in any of the above embodiments and variations.

The lithographic apparatus may comprise an actuator configured to move the substrate W relative to the fluid handling system. Thus, the actuator may be used to control the position of the substrate W (or alternatively, the position of the fluid handling system). The actuator could be, or could comprise, the substrate support (e.g., a substrate table) WT and/or a substrate holder constructed to hold the substrate W and/or the second positioner PW configured to accurately position the substrate support WT.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Where the context allows, embodiments of the invention may be implemented in hardware, firmware, software, or any combination thereof. Embodiments of the invention may also be implemented by instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use ambient (non-vacuum) conditions.

Although specific reference may have been made above to the use of embodiments of the invention in the context of optical lithography, it will be appreciated that the invention, where the context allows, is not limited to optical lithography.

Embodiments include the following numbered clauses:
1. A fluid extraction system for a lithographic apparatus, the fluid extraction system configured to extract fluid, that a fluid handling system comprising a fluid handing structure that is arranged to supply, along a flow path that comprises a gap between an edge of a substrate and an edge of a surrounding structure of the substrate; and a controller arranged to control the flow rate of the fluid in the flow path in dependence on one or more of a property of the substrate, a property of the fluid handling system, a property of the fluid handling structure, a property of the fluid extraction system, and the separation between the fluid handling structure and the fluid extraction system.
2. The fluid extraction system according to clause 1, further comprising a variable valve in the fluid flow path such that the flow rate of the fluid in the fluid flow path is dependent on the variable valve; wherein the controller is arranged to control the variable valve.
3. The fluid extraction system according to clause 1 or 2, wherein the controller is arranged to control the flow rate of the fluid in the flow path such that the flow rate is changeable between any one of plurality of different flow rates between a maximum flow rate and there being no fluid flow.
4. The fluid extraction system according to any preceding clause, wherein the property of the substrate that the controller is arranged to control the flow rate in dependence on is one or more of the height, shape, warpage and contact angle of the substrate.
5. The fluid extraction system according to any preceding clause, wherein controller is arranged to control the flow rate in dependence on is one or more of: the fluid flows within the fluid handling system; the pressure within the fluid flow path; and the separation distance between the fluid handling structure and the substrate.
6. The fluid extraction system according to any preceding clause, wherein the controller is arranged to control the flow rate of the fluid in the flow path so as to reduce the magnitude of the pressure variation in the fluid in the flow path.
7. The fluid extraction system according to any preceding clause, wherein the controller is arranged to control the flow rate of the fluid in the flow path in dependence on a scanning pattern of the substrate.
8. The fluid extraction system according to any preceding clause, wherein the controller is arranged to control the flow rate of the fluid in the flow path in dependence on a control loop.
9. The fluid extraction system according to any preceding clause, wherein the fluid comprises immersion liquid and/or gas.
10. The fluid extraction system according to any preceding clause, further comprising a substrate support for supporting the substrate; wherein the substrate support comprises the surrounding structure of the substrate.
11. A fluid extraction system for a lithographic apparatus, the fluid extraction system configured to extract fluid, that a fluid handling system, comprising a fluid handing structure, is arranged to supply, along a flow path that comprises a gap between an edge of a substrate and an edge of a surrounding structure of the substrate; and a controller arranged to control the flow rate of the fluid along the flow path in dependence on the scanning pattern of the substrate, a property of the substrate, a property of the fluid handling system, a property of the fluid handling structure, a property of the fluid extraction system, and the separation between the fluid handling structure and the fluid extraction system; wherein the controller is arranged to control the flow rate of the fluid in the flow path such that the flow rate is changeable between any one of plurality of different flow rates between a maximum flow rate and there being no fluid flow.
12. A lithographic apparatus comprising: a fluid handling system comprising a fluid handing structure; and the fluid extraction system of any preceding clause; wherein the fluid handling structure is configured to confine immersion liquid to a space between a part of a projection system and a surface of a substrate in the lithographic apparatus whereby a radiation beam projected from the projection system can irradiate the surface of the substrate by passing through the immersion liquid.
13. A device manufacturing method in a lithographic apparatus having a projection system configured to project a radiation beam onto a substrate, and a fluid handling system comprising a fluid handing structure configured to confine immersion liquid to a liquid confinement space between a part of a projection system and a surface of a substrate in the lithographic apparatus whereby a radiation beam projected from the projection system can irradiate the surface of the substrate by passing through the immersion liquid, the method comprising: using the fluid handling structure to confine the immersion liquid to the space between at least a part of the fluid handling structure and the surface of the substrate; projecting a patterned beam of radiation onto the substrate through the immersion liquid in the space; extracting a fluid along a fluid flow path that comprises a gap between an edge of the substrate and an edge of a surrounding structure of the substrate; and controlling the flow rate of the fluid along the fluid flow path in dependence on one or more of a property of the substrate, a property of the fluid handling system, a property of the fluid handling structure, a property of the fluid extraction system, and the separation between the fluid handling structure and the fluid extraction system.
14. The method according to clause 13, further comprising: measuring the height of the substrate; adjusting the separation between the fluid handling structure and the fluid extraction system in dependence on the measured height of the substrate; and controlling the flow rate of the fluid along the fluid flow path in dependence on the measured height of the substrate.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A fluid extraction system for a lithographic apparatus, the fluid extraction system configured to extract fluid, that a fluid handling system, comprising a fluid handling structure, is arranged to supply, along a flow path that comprises a gap between an edge of a substrate and an edge of a surrounding structure of the substrate; and
a controller arranged to control the flow rate of the fluid in the flow path in dependence on one or more of a property of the substrate, a property of the fluid handling system, a property of the fluid handling structure, a property of the fluid extraction system, and the separation between the fluid handling structure and the fluid extraction system.

2. The fluid extraction system according to claim 1, further comprising a variable valve in the fluid flow path such that the flow rate of the fluid in the fluid flow path is dependent on the variable valve;
wherein the controller is arranged to control the variable valve.

3. The fluid extraction system according to claim 1 or 2, wherein the controller is arranged to control the flow rate of the fluid in the flow path such that the flow rate is changeable between any one of plurality of different flow rates between a maximum flow rate and there being no fluid flow.

4. The fluid extraction system according to any preceding claim, wherein the property of the substrate that the controller is arranged to control the flow rate in dependence on is one or more of the height, shape, warpage and contact angle of the substrate.

5. The fluid extraction system according to any preceding claim, wherein controller is arranged to control the flow rate in dependence on is one or more of:
the fluid flows within the fluid handling system;
the pressure within the fluid flow path; and
the separation distance between the fluid handling structure and the substrate.

6. The fluid extraction system according to any preceding claim, wherein the controller is arranged to control the flow rate of the fluid in the flow path so as to reduce the magnitude of the pressure variation in the fluid in the flow path.

7. The fluid extraction system according to any preceding claim, wherein the controller is arranged to control the flow rate of the fluid in the flow path in dependence on a scanning pattern of the substrate.

8. The fluid extraction system according to any preceding claim, wherein the controller is arranged to control the flow rate of the fluid in the flow path in dependence on a control loop.

9. The fluid extraction system according to any preceding claim, wherein the fluid comprises immersion liquid and/or gas.

10. The fluid extraction system according to any preceding claim, further comprising a substrate support for supporting the substrate;
wherein the substrate support comprises the surrounding structure of the substrate.

11. A fluid extraction system for a lithographic apparatus, the fluid extraction system configured to extract fluid, that a fluid handling system, comprising a fluid handling structure, is arranged to supply, along a flow path that comprises a gap between an edge of a substrate and an edge of a surrounding structure of the substrate; and
a controller arranged to control the flow rate of the fluid along the flow path in dependence on the scanning pattern of the substrate, a property of the substrate, a property of the fluid handling system, a property of the fluid handling structure, a property of the fluid extraction system, and the separation between the fluid handling structure and the fluid extraction system;
wherein the controller is arranged to control the flow rate of the fluid in the flow path such that the flow rate is changeable between any one of plurality of different flow rates between a maximum flow rate and there being no fluid flow.

12. A lithographic apparatus comprising:
a fluid handling system comprising a fluid handling structure; and
the fluid extraction system of any preceding claim;
wherein the fluid handling structure is configured to confine immersion liquid to a space between a part of a projection system and a surface of a substrate in the lithographic apparatus whereby a radiation beam projected from the projection system can irradiate the surface of the substrate by passing through the immersion liquid.

13. A device manufacturing method in a lithographic apparatus having a projection system configured to project a radiation beam onto a substrate, and a fluid handling system comprising a fluid handling structure configured to confine immersion liquid to a liquid confinement space between a part of a projection system and a surface of a substrate in the lithographic apparatus whereby a radiation beam projected from the projection system can irradiate the surface of the substrate by passing through the immersion liquid, the method comprising:
using the fluid handling structure to confine the immersion liquid to the space between at least a part of the fluid handling structure and the surface of the substrate; projecting a patterned beam of radiation onto the substrate through the immersion liquid in the space;
extracting a fluid along a fluid flow path that comprises a gap between an edge of the substrate and an edge of a surrounding structure of the substrate; and
controlling the flow rate of the fluid along the fluid flow path in dependence on one or more of a property of the substrate, a property of the fluid handling system, a property of the fluid handling structure, a property of the fluid extraction system, and the separation between the fluid handling structure and the fluid extraction system.

14. The method according to claim 13, further comprising:
measuring the height of the substrate;
adjusting the separation between the fluid handling structure and the fluid extraction system in dependence on the measured height of the substrate; and
controlling the flow rate of the fluid along the fluid flow path in dependence on the measured height of the substrate.
